# NEW EUROPEAN PATENT SPECIFICATION

(11) **EP 0 171 759 B2**
(45) Date of publication and mention of the opposition decision: **20.11.1996**
(45) Mention of the grant of the patent: 02.10.1991
(21) Application number: 85109982.0
(22) Date of filing: 08.08.1985
(51) Int. Cl.: H04N 5/92, H04N 5/93

(54) **Signal-processing apparatus compensating the distortion in a transmitted or recorded signal**
Gerät zur Signalverarbeitung zum Kompensieren der Verzerrung in einem übertragenen oder aufgezeichneten Signal
Dispositif de traitement de signal pour compenser la distorsion dans un signal transmis ou enregistré

(30) Priority: 11.08.1984 JP 168245/84
(43) Date of publication of application: 19.02.1986
(73) Proprietor: MATSUSHITA ELECTRIC INDUSTRIAL CO., LTD., Kadoma-shi, Osaka-fu, 571 (JP)
(72) Inventor: Bannai, Tatsushi, Osaka (JP); Chiba, Mitsuo, Osaka (JP)
(74) Representative: Pellmann, Hans-Bernd, Dipl.-Ing.

(56) References cited:
- EP-A- 0 072 479
- EP-A- 0 210 773
- DE-A- 2 745 337
- DE-A- 3 131 853
- GB-A- 2 113 029
- US-A- 3 715 666
- US-A- 3 717 721
- US-A- 3 809 805
- US-A- 3 885 093
- US-A- 4 151 490
- Zeitschrift "NTZ", 1972, Heft 9, S. 395-400, "Automatische Korrektur linearer Signalverzerrungen in Fernsehsystem (Fasshauer)
- Intern. Broadcasting Conv. (IBC) 1972, Conference Publication No. 88, S. 251-256: Automatic equalisers for analogue television signals (Shelly, Whythe)
- Microwaves, USA, April 1974, pp. 46-50; Lubell, P.D.: Linearizing Amplifiers for Multi-Signal Use
- Rundfunktechn. Mitteilungen, Bd. 12 (1968) H.2, S. 76, "Ableitung von Steuerspannungen aus Prüfzeilenimpulsen" (Fasshauer)

## Description

### BACKGROUND OF THE INVENTION

The present invention relates generally to error compensation particularly advantageous to high quality signal processing apparatus such as video recording and/or reproducing apparatus.

Waveform distortion resulting from the inherent nonlinear characteristics of analog electronic circuitry is of primary concern to the design of high quality signal processing systems. In video recording, the waveform distortion is accounted for not only by the nonlinear characteristics of frequency modulators and demodulators, but by DC drift and clamping voltage deviation which combine to produce a waveform different from the original. Such distortion problem becomes serious when it is desired to record a signal of high information density such as broadcast satellite television signals. It has been proposed to record such a high density video signal by splitting it into two channel components at alternate horizontal lines and expanding them on time scale twice as longer than the duration of the original in an attempt to relax the high quality requirements. If the separated video channels are affected differently from each other on passing through respective analog electronic circuits, horizontal lines are likely to appear to "crawl" on the video screen.

A plurality of error compensation methods and apparatuses and related subjects have been published up to now. Some of the same will be shortly discussed in the following:

Document US-A-3 717 721 describes an automatic chroma compensating system. To error compensate the chroma component of a color video signal produced by a playback apparatus having a plurality of magnetic heads, the amplitude of selected color burst signals derived from the video signal is detected and stored. A difference signal indicative of the difference between adjacent detected amplitude components is generated and added to the stored amplitude components to form a control signal. The amplitude of the chroma component of the composite color video signal is then varied in response to this control signal.

In the error compensating apparatus according to document EP-A-0 072 479 a digital test signal is repeatedly inserted into information signals to be transmitted, and the error between the originally inserted test signal and transmitted test signal received on a reception side is detected on the reception side. The error information is fed back to a tap gain optimizing circuit for optimizing the tap gains of a transversal filter which has been passed by the transmission signal prior to the error detection, said tap gains being determined so as to minimize (compensate) the transmission signal error.

According to document US-A-3 715 666 a similar method is used to rapidly achieve an initial convergence of automatic transversal equalizer tap gain settings.

In the circuit according to document US-A-4 151 490 a reference signal consisting of a low frequency signal and a high frequency signal is transmitted between information signal transmissions, and based on the ratio between the low frequency signal amplitude and the high frequency signal amplitude on the reception side the amount of damping is determined. The determined amount of damping is used as a basis of a frequency characteristic correction.

According to journal "NTZ", 1972, volume 9, pages 395-400: Automatische Korrektur linearer Signalverzerrungen in Fernsehsystemen (Faßhauer), and according to Internat. Broadcasting Conv. (IBC) 1972, Conference Publication No. 88, pages 251-256: Automatic equalisers for analogue television signals (Shelley, Whyte), during the blanking period of a TV signal, a 2T pulse and a 10T or 20T pulse or a 10µs bar is inserted in the signal to be transmitted. On the receiving side, the gain variation and the frequency characteristic is detected, and the gain correction and the filter tap coefficients are varied to correct the frequency characteristic.

According to "Ableitung von Steuerspannungen aus Prüfzeilenimpulsen" (Faßhauer), Rundfunktechn. Mitteilungen, volume 12 (1968), No. 2, page 76, it is known to use for error compensation of video signal distortions a step-like test signal which extends over the whole signal level range of an information signal.

Document "Microwaves", USA, April 1974, pages 46-50 discloses the use of a feed-forward control for eliminating undesired signal components generated by a RF-amplifier.

Document GB-A-2 113 029 discloses a television apparatus using a memory means for multiplying input control signals by a constant (input-signal-independent) factor.

Documents DE-A-27 45 337 and DE-A-31 31 853 disclose means for obtaining a signal having multiple channels. Document DE-A-27 45 337 especially relates to a method for executing channel division for every sample; document DE-A-31 31 853 especially relates to a method in which the time base of a luminance signal of a video signal is expanded and in which the time base of the color signal of the video signal is compressed so that a time division multiplexing is performed and a two-channel signal is obtained.

### SUMMARY OF THE INVENTION

It is the object of the present invention to provide a signal processing apparatus and a video recording and reproducing apparatus having an improved error correction circuit for eliminating waveform distortions affected by a number of error factors.

This object is achieved by the signal processing apparatuses according to the claims 1, 2 and 3, and by the video recording and reproducing apparatuses according to the claims 4, 5 and 7.

### BRIEF DESCRIPTION OF THE DRAWINGS

The present invention will be described in further detail with reference to the accompanying drawings, in which:
Fig. **1** is a schematic block diagram of a preferred embodiment of a video recording and/or reproducing apparatus of the present invention;
Fig. **2** is an illustration of details of the time-expansion and channel separation circuit of Fig. **1**;
Fig. **3** is a timing diagram useful for describing the operation of the circuit of Fig. **2**;
Fig. **4** is a waveform diagram associated with the embodiment of Fig. **1**;
Fig. **5** is an illustration of details of the time-compression and channel recombination circuit of Fig. **1**;
Fig. **6** is a timing diagram useful for describing the operation of the circuit of Fig. **5**;
Fig. **7** is a block diagram of a modified form of the transfer circuit of Fig. **1**;
Fig. **8** is a waveform diagram associated with the embodiment of Fig. **7**;
Fig. **9** is a block diagram of another form of the modification; and
Fig. **10** is a waveform diagram associated with the embodiment of Fig. **9**.

### DETAILED DESCRIPTION

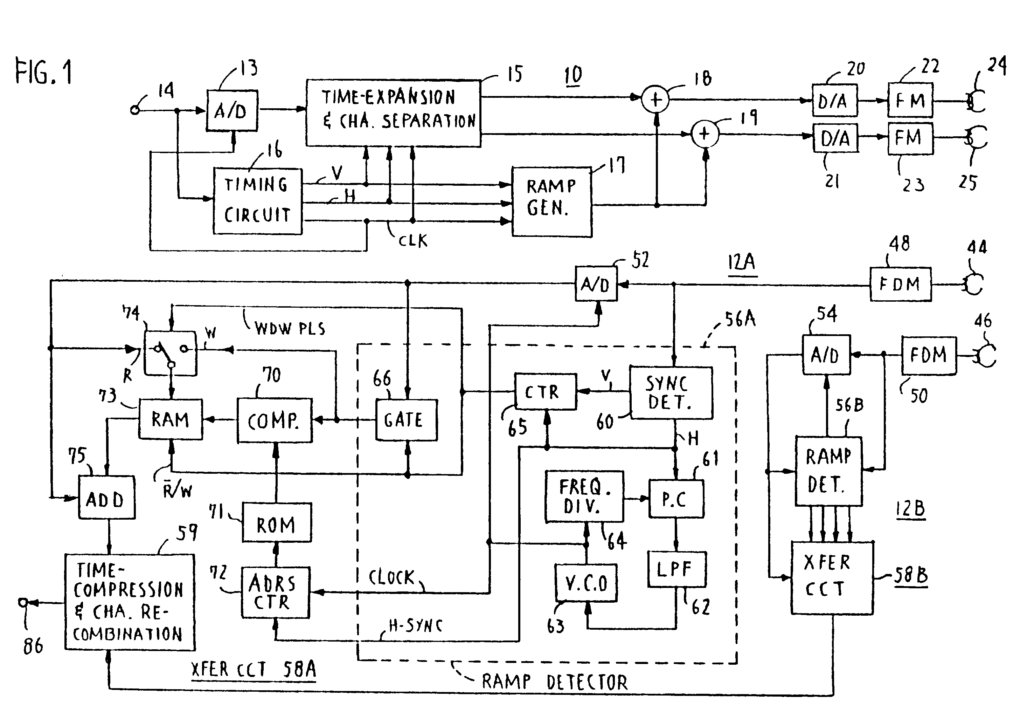

Fig. **1** shows a preferred embodiment of a video tape recording and/or reproducing apparatus in accordance with the present invention. The apparatus generally comprises a two-channel recording circuit **10**, a first channel playback circuit **12A** and a second channel playback circuit **12B**. The two-channel recording circuit **10** comprises an analog-to-digital converter **13** connected to an input terminal **14** to which a high-quality television signal is applied. Such high-quality television signals are transmitted in a frequency modulation format from broadcast satellites and frequency demodulated upon reception before being applied to the input terminal **14**. The input video signal is converted to digital form and applied to a time-expansion and channel separation circuit **15** which expands the time duration of the input signal by twice as much and splits it into two channel components in a manner as will be detailed below.

The analog input signal is also applied to a timing circuit **16**. This timing circuit detects horizontal line sync and vertical blanking pulses and generates clock pulses at a frequency which is an integral multiple of the line frequency and supplies the timing signals including the detected line sync and blanking pulse to time-expansion and channel separation circuit **15** and to a digital ramp generator **17**. The clock pulse is further applied to analog-to-digital converter **13** to synchronize its timing with the time base. Ramp generator **17** includes a counter that initiates counting line sync pulses in response to a blanking pulse from the timing circuit **16** to detect a predetermined line sync within the vertical blanking and further includes a read only memory storing digital ramp data and an address counter which addresses the memory in response to the clock pulse to generate a digital ramp varying stepwisely from the white level to black level of a television picture.

The digital ramp is applied to adders **18** and **19** and inserted to the two-channel video components in the position of the predetermined line sync period of each vertical blanking. The outputs of adders **18** and **19** are converted to analog form by digital-to-analog converters **20**, **21**, frequency modulated by modulators **22**, **23** and fed to video transducer heads **24**, **25**. The video heads **24** and **25** are mounted on the circumference of a rotary drum of any of a well known video tape loading mechanism such that they follow parallel tracks skewed relative to the length of video tape. The reduction of signal density relaxes the quality requirements of video tapes and tape operating mechanisms.

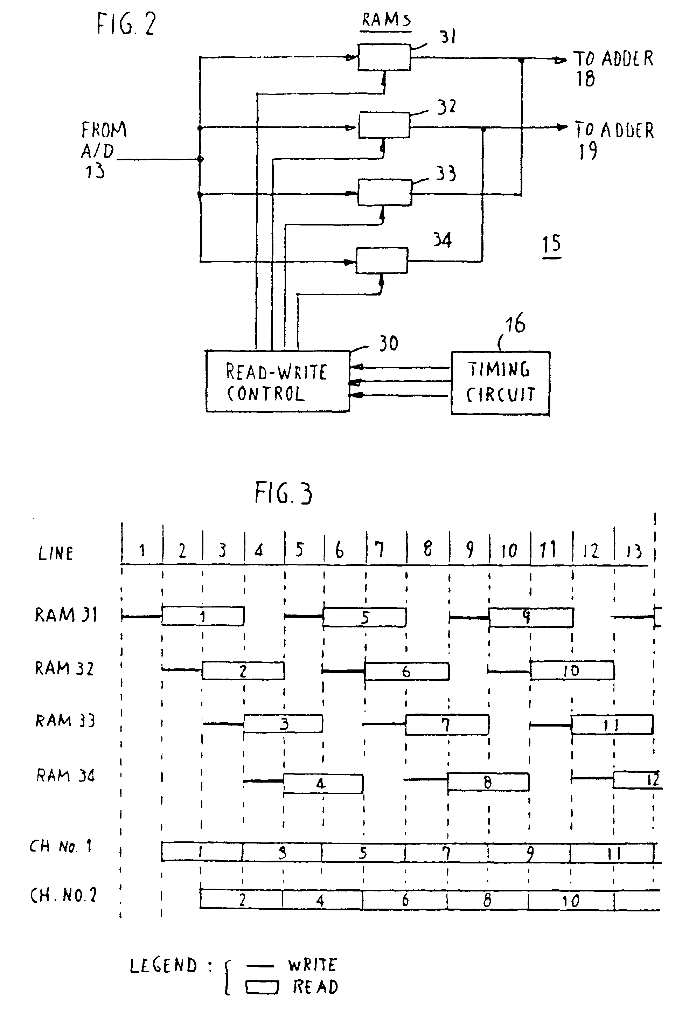

Referring to Fig. **2**, the time-expansion and channel separation circuit **15** includes a plurality of random access memories **31** to **34** and a read-write control circuit **30**. RAMs **31** to **34** have their data input terminals coupled together to the output of analog-to-digital converter **13**, RAMs **31** and **33** having their data output terminals coupled together to the input of adder **18** and RAMs **32** and **34** having their data output terminals coupled together to the input of adder **19**. Read-write control circuit **30** receives the timing pulses from timing circuit **16** to perform read-write operations on the individual memories in accordance with a timing diagram shown in Fig. **3**. Read-write control circuit **30** recyclically addresses RAMs **31** through **34** to write video line signals into the respective RAMs and subsequently read the stored line signals at one half the rate of the write operations. Odd-numbered, time-expanded line signals from RAMs **31** and **33** occur in succession generating a first channel video component as an input signal to adder **18** and even-numbered, time-expanded line signals from RAMs **32** and **34** occur in succession generating a second channel video component as an input signal to adder **19**.

Returning to Fig. **1**, the recorded time-expanded two-channel video components are detected by video heads **44** and **46** and demodulated by frequency demodulators **48**, **50** and passed through known process circuits including amplifiers, filters and clampers, not shown, and converted to digital form by analog-to-digital converters **52** and **54**, respectively. The first channel playback circuit **12A** generally includes a ramp detector **56A** and an error correction or transfer circuit **58A**, and similarly, the second channel playback circuit **12B** generally includes a ramp detector **56B** and a transfer circuit **58B** which are indentical in construction to the circuits **56A** and **58A**, respectively.

The ramp detector **56A** comprises a sync detector **60** which is connected to the demodulator **48** to detect line sync pulse and vertical blanking pulse. A phase-locked loop is provided including a phase comparator **61**, a low-pass filter **62**, a voltage-controlled oscillator **63** and a frequency divider **64**, all of which are connected in a loop so that phase comparator **61** provides phase comparison between the detected line sync pulse and the output of frequency divider **64**. The output of VCO **63** is applied as a clock pulse to the analog-to-digital converter **52** to synchronize its timing with the time base. The ramp detector **56A** further includes a counter **65** and a gate **66**. Counter **65** is connected to sync detector **60** to count the line sync pulses to generate a window pulse. This window pulse is applied to gate **66** connected to the output of analog-to-digital converter **52** to extract the inserted digital ramp from the first-channel digital video component.

The transfer circuit **58A** includes a digital comparator **70** of the type which compares two digital inputs applied thereto and generates a digital output indicating the difference between them, and further includes a read only memory **71** and an address counter **72**. The ROM **71** stores a set of digital instantaneous values of a ramp waveform which are sequentially read out of the memory to one input of the comparator **70** in response to the address counter **72** output. Address counter **72** is connected to VCO **63** and sync detector **60** to generate a series of address codes in response to the clock pulse and repeats the process in response to the line sync pulse to generate a digital ramp waveform, which is applied to comparator **70** as a reference waveform. Comparator **70** receives its second input from the gate **66** to receive the extracted digital ramp to compare it with the reference waveform to detect the difference in digital value which may occur between them. This difference is an instantaneous value indicating the amount and direction of deviation of the instantaneous amplitude value of the reproduced first-channel video signal from the instantaneous amplitude value of the reference waveform.

The instantaneous difference values are sequentially stored as a level correction signal into locations of a random access memory **73** specified by address codes supplied from the output of a switch **74**. RAM **73** is switched to a write mode in response to the window pulse from counter **65** and switched to a read mode in the absence of the window pulse. Switch **74** has a write-address input W connected to the output of gate **66** and a read-address input R connected to the output of analog-to-digital converter **52**. The switch **74** is responsive to the window pulse from counter **65** to establish a path between its write-address input W to the address input of RAM **73** and in the absence of the window pulse it establishes a path between the read-address input R to the address input of RAM **73**.

It will be seen therefore that when a digital ramp occurs the counter **65** supplies a window pulse to switch **74** and the instantaneous amplitude value of the detected digital ramp is applied through switch **74** to the address input of RAM **73**. A set of error correction digital values are stored in locations which can be addressed as a function of the instantaneous level of the reproduced signal. There is therefore a particular error correction value for a particular signal level. When switch **74** is returned to the read-address input position R, the output of analog-to-digital converter **52**, which is affected by the inherent errors, is used to address the RAM **73** to read the error correction values, which are fed to an adder **75** and summed with the video signal from A/D converter **52**.

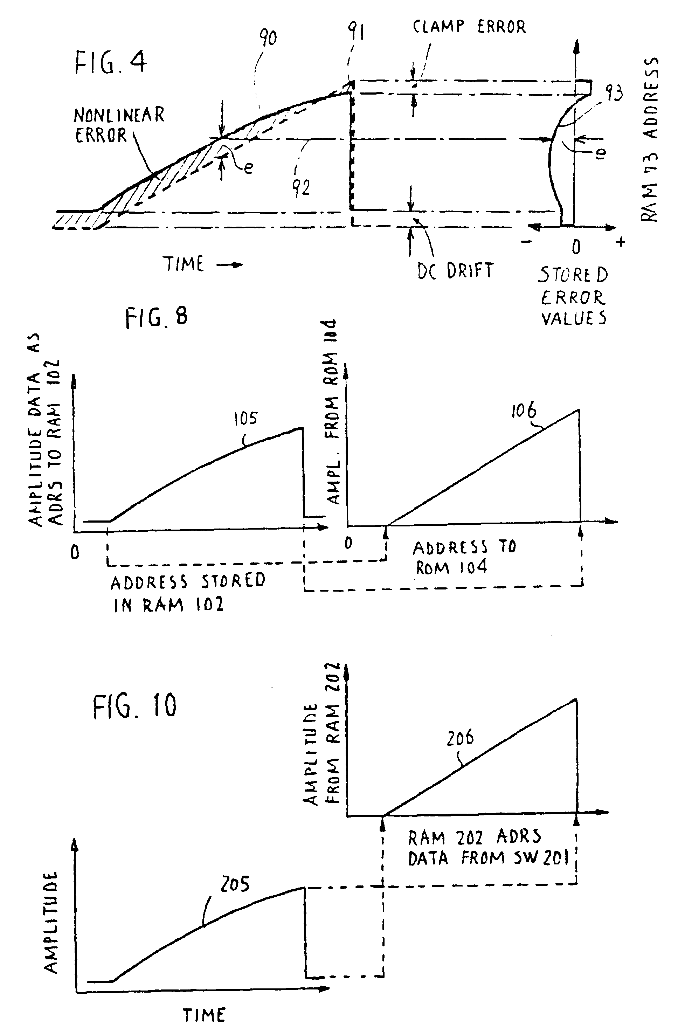

The operation of the transfer circuit **58** of Fig. **1** will be more clearly understood with reference to Fig. **4**. On passing through frequency modulators **22**, **23** prior to recording and on passing through frequency demodulators **48**, **50** and other circuits including amplifiers, filters and clampers (not shown) during playback, the video signals are distorted by nonlinear errors, DC drifts and clamp voltage deviations as indicated by a solid-line reference waveform **90** is detecteed at the output of gate **66** during each vertical blanking interval in response to the window pulse. The comparator **70** detects the difference between the distorted ramp waveform and the reference ramp waveform supplied from ROM **71** and stores a difference signal **93** into RAM 73. For example, the distorted waveform deviates at a given level **92** by an amount "e" from the reference waveform and the difference "e" is stored in RAM **73** in a location specified by the level **92**. A waveform **93** indicates the error values stored in RAM **73**. The addition of the error values to the distorted actual video signals compensates for such errors.

Each of the transfer circuits **58A** and **58B** has therefore a transfer function describing the relationship between the reference and distorted ramp waveforms and transforms the distorted video signal according to the transfer function to a distortion-free waveform. By the error corrective action, the video waveforms on both channels are made substantially equal to each other, thus eliminating "line crawling" which would otherwise occur on the video screen due to the otherwise waveform imbalance between the two channel signals.

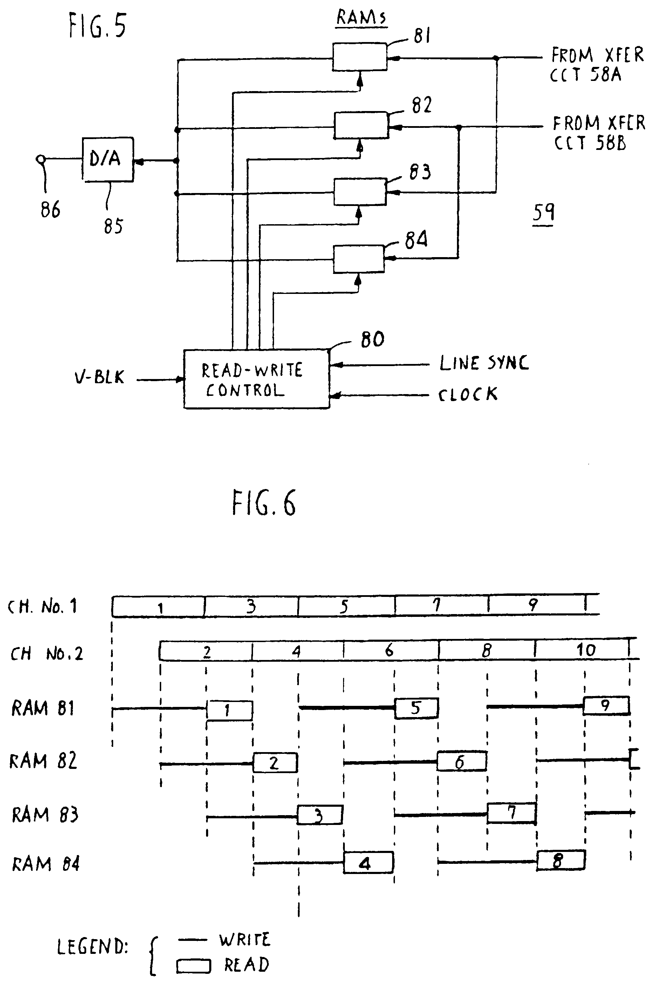

The error compensated outputs of adders **75** of each transfer circuit **58** are supplied to a time-compression and channel recombination circuit **59**. Details of this circuit are shown in Fig. **5**. The time-compression and channel recombination circuit **59** includes a plurality of RAMs **81** through **84** and a read-write control circuit **80**. RAMs **81** and **83** have their data input terminals coupled together to the output of transfer circuit **58A**, RAMs **82** and **84** having their data input terminals coupled together to the output of transfer circuit **58B**. The data output terminals of the RAMs **81** to **84** are connected together to the input of a digital-to-analog converter **85** and thence to a video output terminal **86**.

Read-write control circuit **80** is in receipt of the vertical blanking pulse, line sync pulse and clock pulse from one of the ramp detectors **56A** and **56B** to derive address codes to effect read/write operations in accordance with a timing diagram shown at Fig. **6**. RAMs **81** through **84** are recyclically addressed to store time-expanded line signals in sequence and subsequently the stored signals are read at twice as higher rate than the rate of the write operations. The line signals read from these memories are therefore time-compressed to the original time scale and arranged in the original order of appearance at the input of D/A converter **85**, generating a signal which is a replica of the signal applied to the input terminal **14** of the apparatus.

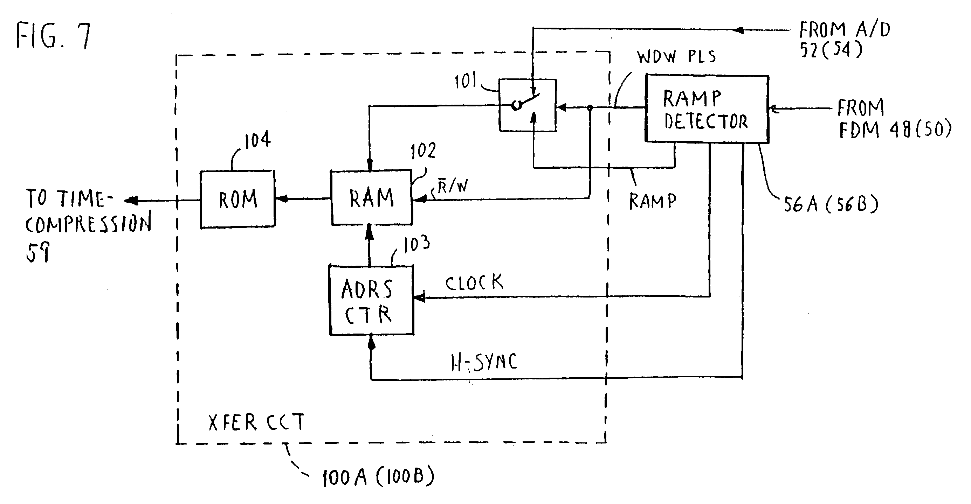

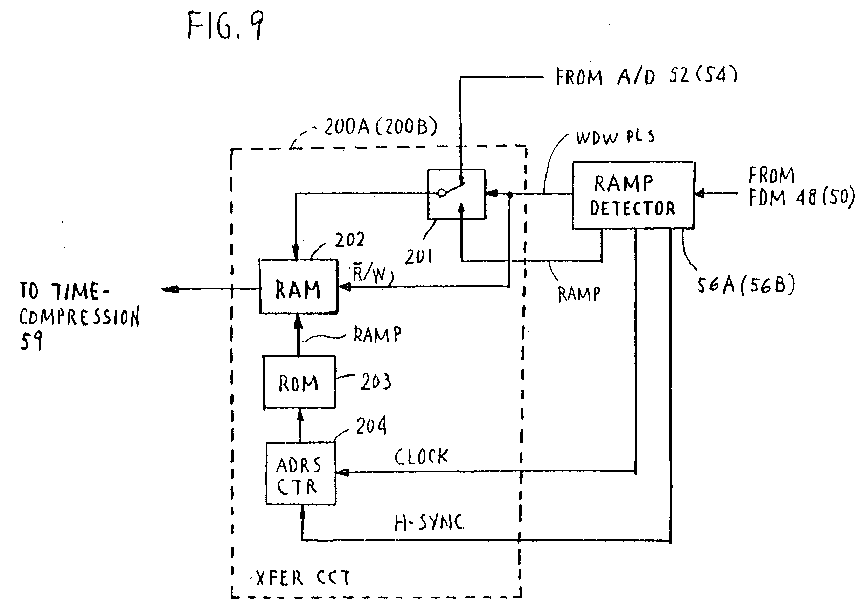

Fig. **7** illustrates a modified form of each transfer circuit, or error corrector. In this modification, the transfer circuit **100** differs from the transfer circuit **58** of the previous embodiment in that it dispenses with the comparator **70** and RAM **102** stores periodic address data supplied to it from address counter **103** as a function of the instantaneous value of the distorted ramp output from the ramp detector **56** via switch **101**. RAM **102** reads the stored address data as a function of the instantaneous value of the actual video signal from A/D converter **52** (or **54**). The instantaneous amplitude value of a distorted ramp waveform **105**, Fig. **8**, is converted to a corresponding address value in RAM **102**. Read only memory **104** stores a reference ramp waveform **106** identical to that inserted to the recorded video signal. The instantaneous value of this stored reference waveform is read as a function of the address data which is in turn read out of RAM **102** as a function of the amplitude data supplied to its address input via switch **101**. If a distorted waveform similar to waveform **105** were applied to RAM **102** when it is being read, a linear ramp waveform would be obtained by ROM **104**. Thus, the transfer circuit **100** has a transfer function describing the relationship between the distorted reference waveform and the undistorted reference waveform and effects waveform conversion on the actual video signal from A/D converter **52** (**54**).

Fig. **9** is an illustration of a further modified form of the transfer circuit which differs from the transfer circuit **100** of Fig. **7** in that ROM **203** which stores the reference ramp waveform is addressed by the output of address counter **204** and supplies a reference ramp to RAM **202** which is addressed by signals supplied to it via switch **201** in a manner similar to RAM **102** of Fig. **7**. In response to a window pulse, RAM **202** is addressed in write mode as a function of the amplitude of a ramp **205**.

Fig. **10**, from detector 56 to store the reference ramp from ROM **203**. If the same distorted ramp were applied to the address input of RAM **202** in a read mode, a linear ramp **206** would be obtained by the memory **202**.

## Claims

1. A signal processing apparatus for processing an analog information signal, comprising
reference inserting means (17, 18, 19) for generating a reference waveform and inserting it at periodic intervals into said information signal, wherein the signal level range of said reference waveform covers the whole signal level range of said information signal,
reference detecting means (56A, 56B) for detecting the inserted reference waveform from the information signal, the detected reference waveform being affected by errors which may be present in the apparatus, and
transfer circuit means (58A, 58B; 100A, 100B; 200A, 200B) having a transfer function describing the relationship between said reference waveform inserted by said inserting means (17, 18, 19) and the error-affected reference waveform for transforming the waveform of said information signal to a distortion-free waveform by modifying an instantaneous amplitude value of said information signal according to the magnitude of said instantaneous amplitude value and according to said relationship described by said transfer function,
said transfer circuit means (58A, 58B; 100A, 100B; 200A, 200B) comprising
waveform generating means (71, 72) for generating a reference waveform identical to the reference waveform inserted by said inserting means (17, 18, 19),
difference detecting means (70) for detecting differences between said error-affected reference waveform and said identical reference waveform, said difference detecting means comprising a memory (73), and a memory control means (74) for writing said detected differences into said memory (73) at addresses which correspond to the amplitude of said error-affected reference waveform and reading the stored differences out of the memory (73) from addresses which correspond to the amplitude of said information signal supplied to said transfer circuit means, and
correcting means (75) for correcting said information signal with said differences detected by said difference detecting means (70, 73, 74), to obtain said distortion-free waveform.

2. A signal processing apparatus for processing an analog information signal, comprising
reference inserting means (17, 18, 19) for generating a reference waveform and inserting it at periodic intervals into said information signal, wherein the signal level range of said reference waveform covers the whole signal level range of said information signal,
reference detecting means (56A, 56B) for detecting the inserted reference waveform from the information signal, the detected reference waveform being affected by errors which may be present in the apparatus, and
transfer circuit means (58A, 58B; 100A, 100B; 200A, 200B) having a transfer function describing the relationship between said reference waveform inserted by said inserting means (17, 18, 19) and the error-affected reference waveform for transforming the waveform of said information signal to a distortion-free waveform by modifying an instantaneous amplitude value of said information signal according to the magnitude of said instantaneous amplitude value and according to said relationship described by said transfer function,
said transfer circuit means (58A, 58B; 100A, 100B; 200A, 200B) comprising
a first memory (102),
means (103) for periodically generating incremental data,
memory control means (101) for writing the data corresponding to a period of the incremental data into said first memory (102) at addresses which correspond to the amplitude of the detected reference waveform and reading the incremental data out of the first memory (102) from addresses which correspond to the amplitude of said information signal, and
a second memory (104) storing a reference waveform identical to the reference waveform inserted by said inserting means (17, 18, 19), said second memory (104) being responsive to said incremental data read out of said first memory (102) for reading the reference waveform stored therein as said distortion-free waveform.

3. A signal processing apparatus for processing an analog information signal, comprising
reference inserting means (17, 18, 19) for generating a reference waveform and inserting it at periodic intervals into said information signal, wherein the signal level range of said reference waveform covers the whole signal level range of said information signal,
reference detecting means (56A, 56B) for detecting the inserted reference waveform from the information signal, the detected reference waveform being affected by errors which may be present in the apparatus, and
transfer circuit means (58A, 58B; 100A, 100B; 200A, 200B) having a transfer function describing the relationship between said reference waveform inserted by said inserting means (17, 18, 19) and the error-affected reference waveform for transforming the waveform of said information signal to a distortion-free waveform by modifying an instantaneous amplitude value of said information signal according to the magnitude of said instantaneous amplitude value and according to said relationship described by said transfer function,
said transfer circuit means (58A, 58B; 100A, 100B; 200A, 200B) comprising
waveform generating means (203, 204) for generating a reference waveform identical to said reference waveform inserted by said inserting means (17, 18, 19),
a memory (202), and
memory control means (201) for writing the instantaneous amplitude value of said reference waveform generated by said waveform generating means (203, 204) into said memory (202) at addresses which correspond to the amplitude of said detected reference waveform and reading the stored amplitude value out of said memory (202) from addresses which correspond to the amplitude of said information signal as said distortion-free waveform.

4. A video recording and reproducing apparatus adapted to receive a video signal, comprising
channel separating means (15) for separating said video signal into a first channel component having odd-numbered lines and a second channel component having even-numbered lines,
reference inserting means (17, 18, 19) operable during the recording mode of the apparatus for generating a reference waveform and inserting it into a vertical blanking period of each of said first and second channel components and applying said components to a recording medium through first and second transducer means (24, 44, 25, 46) respectively, wherein the signal level range of said reference waveform covers the whole signal level range from white level to black level of said video signal,
first reference detecting means (56A) coupled to said first transducer means (24, 44) for detecting the reference waveform from the first channel component reproduced by the first transducer means (24, 44) during playback mode of the apparatus, the detected reference waveform being affected by errors which may be present in the apparatus,
second reference detecting means (56B) coupled to said second transducer means (25, 46) for detecting the reference waveform from the second channel component reproduced by the second transducer means (25, 46) during playback mode of the apparatus, the detected reference waveform being affected by errors which may be present in the apparatus,
first transfer circuit means (58A; 100A; 200A) receptive of said reproduced first channel component and the reference waveform detected by said first detecting means (56A), the first transfer circuit means (58A; 100A; 200A) having a first transfer function describing the relationship between said reference waveform inserted by said inserting means (17, 18, 19) and the error-affected reference waveform detected by said first detecting means (56A) for transforming the waveform of said reproduced first channel component to a first distortion-free waveform by modifying an instantaneous amplitude value of said first channel component according to the magnitude of said instantaneous amplitude value and according to said relationship described by said first transfer function,
second transfer circuit means (58B; 100B; 200B) receptive of said reproduced second channel component and the reference waveform detected by said second detecting means (56B), the second transfer circuit means (58B; 100B; 200B) having a second transfer function describing the relationship between said reference waveform inserted by said inserting means (17, 18, 19) and the error-affected reference waveform detected by said second detecting means (56B) for transforming the waveform of said reproduced second channel component to a second distortion-free waveform by modifying an instantaneous amplitude value of said second channel component according to the magnitude of said instantaneous amplitude value and according to said relationship described by said second transfer function, and
channel recombining means (59) for recombining output signals from said first and second transfer circuit means (58A, 58B; 100A, 100B; 200A, 200B) and generating a signal which is a replica of said video signal,
said first transfer circuit means (58A; 100A; 200A) comprising
first waveform generating means (71, 72) for generating a first reference waveform identical to the reference waveform inserted by said inserting means (17, 18, 19),
first difference detecting means (70) for detecting first differences between the error-affected reference waveform detected by said first detecting means (56A) and the first identical reference waveform, said first difference detecting means comprising a first memory (73), and a first memory control means (74) for writing said first detected differences into said first memory (73) at addresses which correspond to the amplitude of said error-affected reference waveform and reading the stored first differences out of the memory (73) from addresses which correspond to the amplitude of said reproduced first channel component, and
first correcting means (75) for correcting said reproduced first channel component with the differences detected by said first difference detecting means (70, 73, 74), to obtain said first distortion-free waveform, and
said second transfer circuit means (58B; 100B; 200B) comprising
second waveform generating means for generating a second reference waveform identical to the reference waveform inserted by said inserting means (17, 18, 19),
second difference detecting means for detecting second differences between the reference waveform detected by said second detecting means (56B) and said second identical reference waveform, said second difference detecting means comprising a second memory, and a second memory control means for writing said detected second differences into said second memory at addresses which correspond to the amplitude of said error-affected reference waveform and reading the stored second differences out of the memory from addresses which correspond to the amplitude of said reproduced second channel component, and
second correcting means for correcting said reproduced second channel component with the differences detected by said second difference detecting means, to obtain said second distortion-free waveform.

5. A video recording and reproducing apparatus adapted to receive a video signal, comprising
channel separating means (15) for separating said video signal into a first channel component having odd-numbered lines and a second channel component having even-numbered lines,
reference inserting means (17, 18, 19) operable during the recording mode of the apparatus for generating a reference waveform and inserting it into a vertical blanking period of each of said first and second channel components and applying said components to a recording medium through first and second transducer means (24, 44, 25, 46) respectively, wherein the signal level range of said reference waveform covers the whole signal level range from white level to black level of said video signal,
first reference detecting means (56A) coupled to said first transducer means (24, 44) for detecting the reference waveform from the first channel component reproduced by the first transducer means (24, 44) during playback mode of the apparatus, the detected reference waveform being affected by errors which may be present in the apparatus,
second reference detecting means (56B) coupled to said second transducer means (25, 46) for detecting the reference waveform from the second channel component reproduced by the second transducer means (25, 46) during playback mode of the apparatus, the detected reference waveform being affected by errors which may be present in the apparatus,
first transfer circuit means (58A; 100A; 200A) receptive of said reproduced first channel component and the reference waveform detected by said first detecting means (56A), the first transfer circuit means (58A; 100A; 200A) having a first transfer function describing the relationship between said reference waveform inserted by said inserting means (17, 18, 19) and the error-affected reference waveform detected by said first detecting means (56A) for transforming the waveform of said reproduced first channel component to a first distortion-free waveform by modifying an instantaneous amplitude value of said first channel component according to the magnitude of said instantaneous amplitude value and according to said relationship described by said first transfer function,
second transfer circuit means (58B; 100B; 200B) receptive of said reproduced second channel component and the reference waveform detected by said second detecting means (56B), the second transfer circuit means (58B; 100B; 200B) having a second transfer function describing the relationship between said reference waveform inserted by said inserting means (17, 18, 19) and the error-affected reference waveform detected by said second detecting means (56B) for transforming the waveform of said reproduced second channel component to a second distortion-free waveform by modifying an instantaneous amplitude value of said second channel component according to the magnitude of said instantaneous amplitude value and according to said relationship described by said second transfer function, and
channel recombining means (59) for recombining output signals from said first and second transfer circuit means (58A, 58B; 100A, 100B; 200A, 200B) and generating a signal which is a replica of said video signal,
said first transfer circuit means (58A; 100A; 200A) comprising
a first memory (102),
first periodic data generating means (103) for periodically generating first incremental data,
first memory control means (101) for writing the data corresponding to a period of the first incremental data into said first memory (102) at addresses which correspond to the amplitude of the reference waveform detected by said first reference detecting means (56A) and reading the first incremental data out of the first memory (102) from addresses which correspond to the amplitude of said reproduced first channel component, and
a second memory (104) storing a first reference waveform identical to the reference waveform inserted by said inserting means (17, 18, 19), said first reference waveform stored in said second memory (104) being read out in response to said first incremental data read out of said first memory (102) to obtain said first distortion-free waveform, and
said second transfer circuit means (58B; 100B; 200B) comprising
a third memory,
second periodic data generating means for periodically generating second incremental data,
second memory control means for writing the data corresponding to a period of the second incremental data into said third memory at addresses which correspond to the amplitude of the reference waveform detected by said second reference detecting means (56B) and reading the second incremental data out of the third memory from addresses which correspond to the amplitude of said reproduced second channel component, and
a fourth memory storing a second reference waveform identical to the reference waveform inserted by said inserting means (17, 18, 19), said second reference waveform stored in said fourth memory being read out in response to said second incremental data read out of said third memory, to obtain said second distortion-free waveform.

6. A video recording and reproducing apparatus as claimed in claim 5, wherein each of said first and second periodic data generating means (103) comprises
clock generating means for generating a clock pulse synchronously with said reproduced video signal, and
an address counter for counting said clock pulse and cyclically generating a series of address data as each of said incremental data.

7. A video recording and reproducing apparatus adapted to receive a video signal, comprising
channel separating means (15) for separating said video signal into a first channel component having odd-numbered lines and a second channel component having even-numbered lines,
reference inserting means (17, 18, 19) operable during the recording mode of the apparatus for generating a reference waveform and inserting it into a vertical blanking period of each of said first and second channel components and applying said components to a recording medium through first and second transducer means (24, 44, 25, 46) respectively, wherein the signal level range of said reference waveform covers the whole signal level range from white level to black level of said video signal,
first reference detecting means (56A) coupled to said first transducer means (24, 44) for detecting the reference waveform from the first channel component reproduced by the first transducer means (24, 44) during playback mode of the apparatus, the detected reference waveform being affected by errors which may be present in the apparatus,
second reference detecting means (56B) coupled to said second transducer means (25, 46) for detecting the reference waveform from the second channel component reproduced by the second transducer means (25, 46) during playback mode of the apparatus, the detected reference waveform being affected by errors which may be present in the apparatus,
first transfer circuit means (58A; 100A; 200A) receptive of said reproduced first channel component and the reference waveform detected by said first detecting means (56A), the first transfer circuit means (58A; 100A; 200A) having a first transfer function describing the relationship between said reference waveform inserted by said inserting means (17, 18, 19) and the error-affected reference waveform detected by said first detecting means (56A) for transforming the waveform of said reproduced first channel component to a first distortion-free waveform by modifying an instantaneous amplitude value of said first channel component according to the magnitude of said instantaneous amplitude value and according to said relationship described by said first transfer function,
second transfer circuit means (58B; 100B; 200B) receptive of said reproduced second channel component and the reference waveform detected by said second detecting means (56B), the second transfer circuit means (58B; 100B; 200B) having a second transfer function describing the relationship between said reference waveform inserted by said inserting means (17, 18, 19) and the error-affected reference waveform detected by said second detecting means (56B) for transforming the waveform of said reproduced second channel component to a second distortion-free waveform by modifying an instantaneous amplitude value of said second channel component according to the magnitude of said instantaneous amplitude value and according to said relationship described by said second transfer function, and
channel recombining means (59) for recombining output signals from said first and second transfer circuit means (58A, 58B; 100A, 100B; 200A, 200B) and generating a signal which is a replica of said video signal,
said first transfer circuit means (58A; 100A; 200A) comprising
first waveform generating means (203, 204) for generating a first reference waveform identical to said reference waveform inserted by said inserting means (17, 18, 19),
a first memory (202), and
first memory control means (201) for writing the instantaneous amplitude value of said first reference waveform into said first memory (202) at addresses which correspond to the amplitude of the error-affected reference waveform detected by said first reference detecting means (56A) and reading the stored amplitude value out of said first memory (202) from addresses which correspond to the amplitude of said reproduced first channel component to obtain said first distortion-free waveform, and
said second transfer circuit means (58B; 100B; 200B) comprising
second waveform generating means for generating a second reference waveform identical to said reference waveform inserted by said inserting means (17, 18, 19),
a second memory, and
second memory control means for writing the instantaneous amplitude value of said second reference waveform into said second memory at addresses which correspond to the amplitude of the error-affected reference waveform detected by said second reference detecting means (56B) and reading the stored amplitude value out of said second memory from adresses which correspond to the amplitude of said reproduced second channel component to obtain said second distortion-free waveform.

## Patentansprüche

1. Signalaufbereitungseinrichtung zum Verarbeiten eines analogen Informationssignals, enthaltend:
eine Bezugs-Einfügeeinrichtung (17, 18, 19) zum Erzeugen einer Bezugskurvenform und Einfügen derselben in periodischen Abständen in das Informationssignal, wobei der Signalpegelbereich der Bezugskurvenform den gesamten Signalpegelbereich des Informationssignals abdeckt,
eine Bezugs-Erfassungseinrichtung (56A, 56B) zum Erfassen der eingefügten Bezugskurvenform aus dem Informationssignal, wobei die erfaßte Bezugskurvenform durch Fehler beeinflußt ist, die in der Einrichtung auftreten können, und
eine Übertragungsschaltungseinrichtung (58A, 58B; 100A, 100B; 200A, 200B) mit einer Übertragungsfunktion, die den Zusammenhang zwischen der mittels der Einfügeeinrichtung (17, 18, 19) eingefügten Bezugskurvenform und der fehlerbeeinflußten Bezugskurvenform beschreibt, zum Umsetzen der Kurvenform des Informationssignals in eine verzerrungsfreie Kurvenform durch Verändern eines momentanen Amplitudenwerts des Informationssignals entsprechend der Größe des momentanen Amplitudenwerts und entsprechend dem durch die Übertragungsfunktion beschriebenen Zusammenhang,
wobei die Übertragungsschaltungseinrichtung (58A, 58B; 100A, 100B; 200A, 200B)
eine Kurvenformgeneratoreinrichtung (71, 72) zum Erzeugen einer Bezugskurvenform, die mit der mittels der Einfügeeinrichtung (17, 18, 19) eingefügten Bezugskurvenform identisch ist,
eine Differenz-Erfassungseinrichtung (70) zum Erfassen von Differenzen zwischen der fehlerbeeinflußten Bezugskurvenform und der identischen Kurvenform, wobei die Differenz-Erfassungseinrichtung einen Speicher (73) und eine Speichersteuereinrichtung (74) zum Einschreiben der erfaßten Differenzen in den Speicher (73) in der Amplitude der fehlerbeeinflußten Bezugskurvenform entsprechenden Adressen und zum Auslesen der gespeicherten Differenzen aus dem Speicher (73) aus Adressen, die der Amplitude des der Übertragungsschaltungseinrichtung zugeführten Informationssignals entsprechen, und
eine Korrektureinrichtung (75) zum Korrigieren des Informationssignals mit der mittels der Differenz-Erfassungseinrichtung (70, 73, 74) erfaßten Differenzen zum Erhalt der verzerrungsfreien Kurvenform aufweist.

2. Signalaufbereitungseinrichtung zum Verarbeiten eines analogen Informationssignals, enthaltend:
eine Bezugs-Einfügeeinrichtung (17, 18, 19) zum Erzeugen einer Bezugskurvenform und Einfügen derselben in periodischen Abständen in das Informationssignal, wobei der Signalpegelbereich der Bezugskurvenform den gesamten Signalpegelbereich des Informationssignals abdeckt,
eine Bezugs-Erfassungseinrichtung (56A, 56B) zum Erfassen der eingefügten Bezugskurvenform aus dem Informationssignal, wobei die erfaßte Bezugskurvenform durch Fehler beeinflußt ist, die in der Einrichtung auftreten können, und
eine Übertragungsschaltungseinrichtung (58A, 58B; 100A, 100B; 200A, 200B) mit einer Übertragungsfunktion, die den Zusammenhang zwischen der mittels der Einfügeeinrichtung (17, 18, 19) eingefügten Bezugskurvenform und der fehlerbeeinflußten Bezugskurvenform beschreibt, zum Umsetzen der Kurvenform des Informationssignals in eine verzerrungsfreie Kurvenform durch Verändern eines momentanen Amplitudenwerts des Informationssignals entsprechend der Größe des momentanen Amplitudenwerts und entsprechend dem durch die Übertragungsfunktion beschriebenen Zusammenhang,
wobei die Übertragungsschaltungseinrichtung (58A, 58B; 100A, 100B; 200A, 200B)
einen ersten Speicher (102),
eine Einrichtung (103) zum periodischen Erzeugen von Inkrementaldaten,
eine Speichersteuereinrichtung (101) zum Einschreiben der einer Periode der Inkrementaldaten entsprechenden Daten in den ersten Speicher (102) in der Amplitude der erfaßten Bezugskurvenform entsprechende Adressen und zum Auslesen der Inkrementaldaten aus dem ersten Speicher (102) aus der Amplitude des Informationssignals entsprechenden Adressen und
einen zweiten Speicher (104) aufweist, der eine mit der mittels der Einfügeeinrichtung (17, 18, 19) eingefügten Bezugskurvenform identische Bezugskurvenform speichert, wobei der zweite Speicher (104) auf die aus dem ersten Speicher (102) ausgelesenen Inkrementaldaten durch Auslesen der eingespeicherten Bezugskurvenform als verzerrungsfreie Kurvenform anspricht.

3. Signalaufbereitungseinrichtung zum Verarbeiten eines analogen Informationssignals, enthaltend:
eine Bezugs-Einfügeeinrichtung (17, 18, 19) zum Erzeugen einer Bezugskurvenform und Einfügen derselben in periodischen Abständen in das Informationssignal, wobei der Signalpegelbereich der Bezugskurvenform den gesamten Signalpegelbereich des Informationssignals abdeckt,
eine Bezugs-Erfassungseinrichtung (56A, 56B) zum Erfassen der eingefügten Bezugskurvenform aus dem Informationssignal, wobei die erfaßte Bezugskurvenform durch Fehler beeinflußt ist, die in der Einrichtung auftreten können, und
eine Übertragungsschaltungseinrichtung (58A, 58B; 100A, 100B; 200A, 200B) mit einer Übertragungsfunktion, die den Zusammenhang zwischen der mittels der Einfügeeinrichtung (17, 18, 19) eingefügten Bezugskurvenform und der fehlerbeeinflußten Bezugskurvenform beschreibt, zum Umsetzen der Kurvenform des Informationssignals in eine verzerrungsfreie Kurvenform durch Verändern eines momentanen Amplitudenwerts des Informationssignals entsprechend der Größe des momentanen Amplitudenwerts und entsprechend dem durch die Übertragungsfunktion beschriebenen Zusammenhang,
wobei die Übertragungsschaltungseinrichtung (58A, 58B; 100A, 100B; 200A, 200B)
eine Kurvenformgeneratoreinrichtung (203, 204) zum Erzeugen einer Bezugskurvenform, die mit der mittels der Einfügeeinrichtung (17, 18, 19) eingefügten Bezugskurvenform identisch ist,
einen Speicher (202) und
eine Speichersteuereinrichtung (201) zum Einschreiben des momentanen Amplitudenwerts der mittels der Kurvenformgeneratoreinrichtung (203, 204) erzeugen Bezugskurvenform in den Speicher (202) in der Amplitude der erfaßten Bezugskurvenform entsprechende Adressen und zum Auslesen des gespeicherten Amplitudenwertes aus dem Speicher (202) aus der Amplitude des Informationssignals entsprechenden Adressen als verzerrungsfreie Kurvenform aufweist.

4. Videoaufzeichnungs- und wiedergabegerät zur Aufnahme eines Videosignals, enthaltend:
eine Kanaltrenneinrichtung (15) zum Aufteilen des Videosignals in eine erste Kanalkomponente mit ungeradzahligen Zeilen und eine zweite Kanalkomponente mit geradzahligen Zeilen,
eine Bezugs-Einfügeeinrichtung (17, 18, 19), die während des Aufzeichnungsbetriebs des Geräts zum Erzeugen einer Bezugskurvenform und Einfügen derselben in eine Vertikalaustastperiode einer jeden ersten und zweiten Kanalkomponente und zum Aufbringen der Komponenten auf ein Aufzeichnungsmaterial über eine erste bzw. zweite Wandlereinrichtung (24, 44, 25, 46) betreibbar ist, wobei der Signalpegelbereich der Bezugskurvenform den gesamten Signalpegelbereich von einem Weißpegel bis zu einem Schwarzpegel des Videosignals abdeckt,
eine an die erste Wandlereinrichtung (24, 44) angeschlossene erste Bezugs-Erfassungseinrichtung (56A) zum Erfassen der Bezugskurvenform aus der mittels der ersten Wandlereinrichtung (24, 44) während des Wiedergabebetriebs des Geräts reproduzierten ersten Kanalkomponente, wobei die erfaßte Bezugskurvenform durch Fehler beeinflußt ist, die im Gerät auftreten können,
eine an die zweite Wandlereinrichtung (25, 46) angeschlossene zweite Bezugs-Erfassungseinrichtung (56B) zum Erfassen der Bezugskurvenform aus der mittels der zweiten Wandlereinrichtung (25, 46) während des Wiedergabebetriebs des Geräts reproduzierten zweiten Kanalkomponente, wobei die erfaßte Bezugskurvenform durch Fehler beeinflußt ist, die in dem Gerät auftreten können,
eine erste Übertragungsschaltungseinrichtung (58A; 100A, 200A), die die reproduzierte erste Kanalkomponente und die mittels der ersten Erfassungseinrichtung (56A) erfaßte Bezugskurvenform aufnimmt, wobei die erste Übertragungsschaltungseinrichtung (58A; 100A; 200A) eine erste Übertragungsfunktion hat, die den Zusammenhang zwischen der mittels der Einfügeeinrichtung (17, 18, 19) eingefügten Bezugskurvenform und der mittels der ersten Erfassungseinrichtung (56A) erfaßten, fehlerbeeinflußten Bezugskurvenform beschreibt, zum Umsetzen der Kurvenform der reproduzierten ersten Kanalkomponente in eine erste verzerrungsfreie Kurvenform durch Verändern eines momentanen Amplitudenwerts der ersten Kanalkomponente entsprechend der Größe des momentanen Amplitudenwerts und entsprechend dem durch die erste Übertragungsfunktion beschriebenen Zusammenhang,
eine zweite Übertragungsschaltungseinrichtung (58B; 100B; 200B), die die reproduzierte zweite Kanalkomponente und die mittels der zweiten Erfassungseinrichtung (56B) erfaßte Bezugskurvenform aufnimmt, wobei die zweite Übertragungsschaltungseinrichtung (58B; 100B; 200B) eine zweite Übertragungsfunktion hat, die den Zusammenhang zwischen der mittels der Einfügeeinrichtung (17, 18, 19) eingefügten Bezugskurvenform und der mittels der zweiten Erfassungseinrichtung (56B) erfaßten, fehlerbeeinflußten Bezugskurvenform beschreibt, zum Umsetzen der Kurvenform der reproduzierten zweiten Kanalkomponente in eine zweite verzerrungsfreie Kurvenform durch Ändern eines momentanen Amplitudenwerts der zweiten Kanalkomponente entsprechend der Größe des momentanen Amplitudenwerts und entsprechend dem durch die zweite Übertragungsfunktion beschriebenen Zusammenhang, und
eine Kanalrekombinationseinrichtung (59) zum Zusammensetzen der Ausgangssignale der ersten und der zweiten Übertragungsschaltungseinrichtung (58A, 58B; 100A, 100B; 200A, 200B) und zum Erzeugen eines Signals, das eine Nachbildung des Videosignals ist,
wobei die erste Übertragungsschaltungseinrichtung (58A; 100A, 200A)
eine erste Kurvenformgeneratoreinrichtung (71, 72) zum Erzeugen einer ersten Bezugskurvenform, die mit der mittels der Einfügeeinrichtung (17, 18, 19) eingefügten Bezugskurvenform identisch ist,
eine erste Differenz-Erfassungseinrichtung (70) zum Erfassen von ersten Differenzen zwischen der mittels der ersten Erfassungseinrichtung (56A) erfaßten, fehlerbeeinflußten Bezugskurvenform und der ersten identischen Bezugskurvenform, wobei die erste Differenz-Erfassungseinrichtung einen ersten Speicher (73) und eine erste Speichersteuereinrichtung (74) zum Einschreiben der ersten erfaßten Differenzen in den ersten Speicher (73) in der Amplitude der fehlerbeeinflußten Bezugskurvenform entsprechende Adressen und zum Auslesen der gespeicherten ersten Differenzen aus dem Speicher (73) aus der Amplitude der reproduzierten ersten Kanalkomponente entsprechenden Adressen, und
eine erste Korrektureinrichtung (75) zum Korrigieren der reproduzierten ersten Kanalkomponente mit der mittels der ersten Differenz-Erfassungseinrichtung (70, 73, 74) erfaßten Differenzen zum Erhalt der ersten verzerrungsfreien Kurvenform aufweist, und
wobei die zweite Übertragungsschaltungseinrichtung (58B; 100B; 200B)
eine zweite Kurvenformgeneratoreinrichtung zum Erzeugen einer zweiten Bezugskurvenform, die mit der mittels der Einfügeeinrichtung (17, 18, 19) eingefügten Bezugskurvenform identisch ist,
eine zweite Differenz-Erfassungseinrichtung zum Erfassen von zweiten Differenzen zwischen der mittels der zweiten Erfassungseinrichtung (56B) erfaßten Bezugskurvenform und der zweiten identischen Bezugskurvenform, wobei die zweite Differenz-Erfassungseinrichtung einen zweiten Speicher und eine zweite Speichersteuereinrichtung zum Einschreiben der erfaßten zweiten Differenzen in den zweiten Speicher in der Amplitude der fehlerbeeinflußten Bezugskurvenform entsprechende Adressen und zum Auslesen der gespeicherten zweiten Differenzen aus dem Speicher aus der Amplitude der reproduzierten zweiten Kanalkomponente entsprechenden Adressen aufweist, und
eine zweite Korrektureinrichtung zum Korrigieren der reproduzierten zweiten Kanalkomponente mit der mittels der zweiten Differenz-Erfassungseinrichtung erfaßten Differenzen zum Erhalt der zweiten verzerrungsfreien Kurvenform aufweist.

5. Videoaufzeichnungs- und wiedergabegerät zur Aufnahme eines Videosignals, enthaltend:
eine Kanaltrenneinrichtung (15) zum Aufteilen des Videosignals in eine erste Kanalkomponente mit ungeradzahligen Zeilen und eine zweite Kanalkomponente mit geradzahligen Zeilen,
eine Bezugs-Einfügeeinrichtung (17, 18, 19), die während des Aufzeichnungsbetriebs des Geräts zum Erzeugen einer Bezugskurvenform und Einfügen derselben in eine Vertikalaustastperiode einer jeden ersten und zweiten Kanalkomponente und zum Aufbringen der Komponenten auf ein Aufzeichnungsmaterial über eine erste bzw. zweite Wandlereinrichtung (24, 44, 25, 46) betreibbar ist, wobei der Signalpegelbereich der Bezugskurvenform den gesamten Signalpegelbereich von einem Weißpegel bis zu einem Schwarzpegel des Videosignals abdeckt,
eine an die erste Wandlereinrichtung (24, 44) angeschlossene erste Bezugs-Erfassungseinrichtung (56A) zum Erfassen der Bezugskurvenform aus der mittels der ersten Wandlereinrichtung (24, 44) während des Wiedergabebetriebs des Geräts reproduzierten ersten Kanalkomponente, wobei die erfaßte Bezugskurvenform durch Fehler beeinflußt ist, die im Gerät auftreten können,
eine an die zweite Wandlereinrichtung (25, 46) angeschlossene zweite Bezugs-Erfassungseinrichtung (56B) zum Erfassen der Bezugskurvenform aus der mittels der zweiten Wandlereinrichtung (25, 46) während des Wiedergabebetriebs des Geräts reproduzierten zweiten Kanalkomponente, wobei die erfaßte Bezugskurvenform durch Fehler beeinflußt ist, die in dem Gerät auftreten können,
eine erste Übertragungsschaltungseinrichtung (58A; 100A, 200A), die die reproduzierte erste Kanalkomponente und die mittels der ersten Erfassungseinrichtung (56A) erfaßte Bezugskurvenform aufnimmt, wobei die erste Übertragungsschaltungseinrichtung (58A; 100A; 200A) eine erste Übertragungsfunktion hat, die den Zusammenhang zwischen der mittels der Einfügeeinrichtung (17, 18, 19) eingefügten Bezugskurvenform und der mittels der ersten Erfassungseinrichtung (56A) erfaßten, fehlerbeeinflußten Bezugskurvenform beschreibt, zum Umsetzen der Kurvenform der reproduzierten ersten Kanalkomponente in eine erste verzerrungsfreie Kurvenform durch Verändern eines momentanen Amplitudenwerts der ersten Kanalkomponente entsprechend der Größe des momentanen Amplitudenwerts und entsprechend dem durch die erste Übertragungsfunktion beschriebenen Zusammenhang,
eine zweite Übertragungsschaltungseinrichtung (58B; 100B; 200B), die die reproduzierte zweite Kanalkomponente und die mittels der zweiten Erfassungseinrichtung (56B) erfaßte Bezugskurvenform aufnimmt, wobei die zweite Übertragungsschaltungseinrichtung (58B; 100B; 200B) eine zweite Übertragungsfunktion hat, die den Zusammenhang zwischen der mittels der Einfügeeinrichtung (17, 18, 19) eingefügten Bezugskurvenform und der mittels der zweiten Erfassungseinrichtung (56B) erfaßten, fehlerbeeinflußten Bezugskurvenform beschreibt, zum Umsetzen der Kurvenform der reproduzierten zweiten Kanalkomponente in eine zweite verzerrungsfreie Kurvenform durch Ändern eines momentanen Amplitudenwerts der zweiten Kanalkomponente entsprechend der Größe des momentanen Amplitudenwerts und entsprechend dem durch die zweite Übertragungsfunktion beschriebenen Zusammenhang, und
eine Kanalrekombinationseinrichtung (59) zum Zusammensetzen der Ausgangssignale der ersten und der zweiten Übertragungsschaltungseinrichtung (58A, 58B; 100A, 100B; 200A, 200B) und zum Erzeugen eines Signals, das eine Nachbildung des Videosignals ist,
wobei die erste Übertragungsschaltungseinrichtung (58A; 100A; 200A)
einen ersten Speicher (102),
eine erste Periodendaten-Generatoreinrichtung (103) zum periodischen Erzeugen erster Inkrementaldaten,
eine erste Speichersteuereinrichtung (101) zum Einschreiben der einer Periode der ersten Inkrementaldaten entsprechenden Daten in den ersten Speicher (102) aus der Amplitude der mittels der ersten Bezugs-Erfassungseinrichtung (56A) erfaßten Bezugskurvenform entsprechenden Adressen und zum Auslesen der ersten Inkrementaldaten aus dem ersten Speicher (102) aus der Amplitude der reproduzierten ersten Kanalkomponente entsprechenden Adressen und
einen zweiten Speicher (104) aufweist, der eine erste Bezugskurvenform speichert, die mit der mittels der Einfügeeinrichtung (17, 18, 19) eingefügten Bezugskurvenform identisch ist, wobei der zweite Speicher (104) im Ansprechen auf die aus dem ersten Speicher (102) ausgelesenen ersten Inkrementaldaten zum Erhalt der ersten verzerrungsfreien Kurvenform die gespeicherte erste Bezugskurvenform ausliest und
wobei die zweite Übertragungsschaltungseinrichtung (58B; 100B; 200B)
einen dritten Speicher,
eine zweite Periodendaten-Generatoreinrichtung zum periodischen Erzeugen zweiter Inkrementaldaten,
eine zweite Speichersteuereinrichtung zum Einschreiben der einer Periode der zweiten Inkrementaldaten entsprechenden Daten in den dritten Speicher in der Amplitude der mittels der zweiten Bezugs-Erfassungseinrichtung (56B) erfaßten Bezugskurvenform entsprechenden Adressen und zum Auslesen der zweiten Inkrementaldaten aus dem dritten Speicher aus der Amplitude der reproduzierten zweiten Kanalkomponente entsprechenden Adressen und
einen vierten Speicher aufweist, der eine zweite Bezugskurvenform speichert, die mit der mittels der Einfügeeinrichtung (17, 18, 19) eingefügten Bezugskurvenform identisch ist, wobei der vierte Speicher im Ansprechen auf die aus dem dritten Speicher ausgelesenen zweiten Inkrementaldaten zum Erhalt der zweiten verzerrungsfreien Kurvenform die gespeicherte zweite Bezugskurvenform ausliest.

6. Videoaufzeichnungs- und wiedergabegerät nach Anspruch 5, wobei die erste sowie die zweite Periodendaten-Generatoreinrichtung (103) jeweils
eine Taktgeneratoreinrichtung zum mit dem reproduzierten Videosignal synchronen Erzeugen von Taktimpulsen und
einen Adressenzähler zum Zählen der Taktimpulse und zum umlaufenden Erzeugen einer Reihe von Adressendaten als jeweilige Inkrementaldaten aufweist.

7. Videoaufzeichnungs- und wiedergabegerät zur Aufnahme eines Videosignals, enthaltend:
eine Kanaltrenneinrichtung (15) zum Aufteilen des Videosignals in eine erste Kanalkomponente mit ungeradzahligen Zeilen und eine zweite Kanalkomponente mit geradzahligen Zeilen,
eine Bezugs-Einfügeeinrichtung (17, 18, 19), die während des Aufzeichnungsbetriebs des Geräts zum Erzeugen einer Bezugskurvenform und Einfügen derselben in eine Vertikalaustastperiode einer jeden ersten und zweiten Kanalkomponente und zum Aufbringen der Komponenten auf ein Aufzeichnungsmaterial über eine erste bzw. zweite Wandlereinrichtung (24, 44, 25, 46) betreibbar ist, wobei der Signalpegelbereich der Bezugskurvenform den gesamten Signalpegelbereich von einem Weißpegel bis zu einem Schwarzpegel des Videosignals abdeckt,
eine an die erste Wandlereinrichtung (24, 44) angeschlossene erste Bezugs-Erfassungseinrichtung (56A) zum Erfassen der Bezugskurvenform aus der mittels der ersten Wandlereinrichtung (24, 44) während des Wiedergabebetriebs des Geräts reproduzierten ersten Kanalkomponente, wobei die erfaßte Bezugskurvenform durch Fehler beeinflußt ist, die in dem Gerät auftreten können,
eine an die zweite Wandlereinrichtung (25, 46) angeschlossene zweite Bezugs-Erfassungseinrichtung (56B) zum Erfassen der Bezugskurvenform aus der mittels der zweiten Wandlereinrichtung (25, 46) während des Wiedergabebetriebs des Geräts reproduzierten zweiten Kanalkomponente, wobei die erfaßte Bezugskurvenform durch Fehler beeinflußt ist, die in dem Gerät auftreten können,
eine erste Übertragungsschaltungseinrichtung (58A; 100A, 200A), die die reproduzierte erste Kanalkomponente und die mittels der ersten Erfassungseinrichtung (56A) erfaßte Bezugskurvenform aufnimmt, wobei die erste Übertragungsschaltungseinrichtung (58A; 100A; 200A) eine erste Übertragungsfunktion hat, die den Zusammenhang zwischen der mittels der Einfügeeinrichtung (17, 18, 19) eingefügten Bezugskurvenform und der mittels der ersten Erfassungseinrichtung (56A) erfaßten, fehlerbeeinflußten Bezugskurvenform beschreibt, zum Umsetzen der Kurvenform der reproduzierten ersten Kanalkomponente in eine erste verzerrungsfreie Kurvenform durch Verändern eines momentanen Amplitudenwerts der ersten Kanalkomponente entsprechend der Größe des momentanen Amplitudenwerts und entsprechend dem durch die erste Übertragungsfunktion beschriebenen Zusammenhang,
eine zweite Übertragungsschaltungseinrichtung (58B; 100B; 200B), die die reproduzierte zweite Kanalkomponente und die mittels der zweiten Erfassungseinrichtung (56B) erfaßte Bezugskurvenform aufnimmt, wobei die zweite Übertragungsschaltungseinrichtung (58B; 100B; 200B) eine zweite Übertragungsfunktion hat, die den Zusammenhang zwischen der mittels der Einfügeeinrichtung (17, 18, 19) eingefügten Bezugskurvenform und der mittels der zweiten Erfassungseinrichtung (56B) erfaßten, fehlerbeeinflußten Bezugskurvenform beschreibt, zum Umsetzen der Kurvenform der reproduzierten zweiten Kanalkomponente in eine zweite verzerrungsfreie Kurvenform durch Ändern eines momentanen Amplitudenwerts der zweiten Kanalkomponente entsprechend der Größe des momentanen Amplitudenwerts und entsprechend dem durch die zweite Übertragungsfunktion beschriebenen Zusammenhang, und
eine Kanalrekombinationseinrichtung (59) zum Zusammensetzen der Ausgangssignale der ersten und der zweiten Übertragungsschaltungseinrichtung (58A, 58B; 100A, 100B; 200A, 200B) und zum Erzeugen eines Signals, das eine Nachbildung des Videosignals ist,
wobei die erste Übertragungsschaltungseinrichtung (58A; 100A; 200A)
eine erste Kurvenform-Generatoreinrichtung (203, 204) zum Erzeugen einer ersten Bezugskurvenform, die mit der mittels der Einfügeeinrichtung (17, 18, 19) eingefügten Bezugskurvenform identisch ist,
einen ersten Speicher (202) und
eine erste Speichersteuereinrichtung (201) zum Einschreiben des momentanen Amplitudenwerts der ersten Bezugskurvenform in den ersten Speicher (202) in der Amplitude der mittels der ersten Bezugs-Erfassungseinrichtung (56A) erfaßten, fehlerbeeinflußten Bezugskurvenform entsprechenden Adressen und zum Auslesen des gespeicherten Amplitudenwertes aus dem ersten Speicher (202) aus der Amplitude der reproduzierten ersten Kanalkomponente entsprechenden Adressen zum Erhalt der ersten verzerrungsfreien Kurvenform aufweist, und
wobei die zweite Übertragungsschaltungseinrichtung (58B; 100B; 200B)
eine zweite Kurvenform-Generatoreinrichtung zum Erzeugen einer zweiten Bezugskurvenform, die mit der mittels der Einfügeeinrichtung (17, 18, 19) eingefügten Bezugskurvenform identisch ist,
einen zweiten Speicher und
eine zweite Speichersteuereinrichtung zum Einschreiben des momentanen Amplitudenwerts der zweiten Bezugskurvenform in den zweiten Speicher in der Amplitude der mittels der zweiten Bezugs-Erfassungseinrichtung (56B) erfaßten, fehlerbeeinflußten Bezugskurvenform entsprechenden Adressen und zum Auslesen des gespeicherten Amplitudenwerts aus dem zweiten Speicher aus der Amplitude der reproduzierten zweiten Kanalkomponente entsprechenden Adressen zum Erhalt der zweiten verzerrungsfreien Kurvenform aufweist.

## Revendications

1. Appareil de traitement du signal pour traiter un signal d'information analogique, comportant :
des moyens d'insertion de référence (17, 18, 19) pour générer une forme d'onde de référence et pour l'insérer à intervalles périodiques dans ledit signal d'information, la plage de niveaux de signal de ladite forme d'onde de référence couvrant toute la plage de niveaux de signal dudit signal d'information,
des moyens de détection de référence (56A, 56B) pour détecter dans le signal d'information la forme d'onde de référence insérée, la forme d'onde de référence détectée étant affectée par des erreurs qui peuvent être présentes dans l'appareil, et
des moyens formant circuit de transfert (58A, 58B; 100A, 100B; 200A, 200B) ayant une fonction de transfert décrivant la relation entre ladite forme d'onde de référence insérée par lesdits moyens d'insertion (17, 18, 19) et la forme d'onde de référence affectée par les erreurs afin de transformer la forme d'onde dudit signal d'information en une forme d'onde exempte de distorsion en modifiant la valeur d'amplitude instantanée dudit signal d'information en fonction de la grandeur de ladite valeur d'amplitude instantanée et en fonction de ladite relation décrite par ladite fonction de transfert,
lesdits moyens formant circuit de transfert (58A, 58B; 100A, 100B; 200A, 200B) comprenant :
des moyens (71, 72) de génération de forme d'onde de référence identique à la forme d'onde de référence insérée par lesdits moyens d'insertion (17, 18, 19),
des moyens (70) de détection de différence pour détecter les différences entre ladite forme d'onde de référence affectée par des erreurs et ladite forme d'onde de référence identique, lesdits moyens de détection de référence comprenant une mémoire (73), et un moyen de contrôle de mémoire (74) pour écrire dans ladite mémoire (73), à des adresses qui correspondent à l'amplitude de ladite forme d'onde de référence affectée par des erreurs, ladite différence détectée et pour extraire de la mémoire (73), à partir d'adresses qui correspondent à l'amplitude dudit signal d'information fourni auxdits moyens formant circuit de transfert, et
des moyens de correction (75) pour corriger ledit signal d'information à l'aide desdites différences détectées par lesdits moyens (70, 73, 74) de détection de différence afin d'obtenir ladite forme d'onde exempte de distorsion.

2. Appareil de traitement de signal pour traiter un signal d'information analogique, comprenant :
des moyens d'insertion de référence (17, 18, 19) pour générer une forme d'onde de référence et l'insérer, à des intervalles périodiques, dans ledit signal d'information, la plage de niveaux de signal de ladite forme d'onde de référence couvrant toute la plage de niveaux de signal dudit signal d'information,
des moyens de détection de référence (56A, 56B) pour détecter dans le signal d'information la forme d'onde de référence insérée, la forme d'onde de référence détectée étant affectée par des erreurs qui peuvent être présentes dans l'appareil, et
des moyens formant circuit de transfert (58A, 58B; 100A, 100B; 200A, 200B) ayant une fonction de transfert décrivant la relation entre ladite forme d'onde de référence insérée par lesdits moyens d'insertion (17, 18, 19) et la forme d'onde de référence affectée par des erreurs pour transformer la forme d'onde dudit signal d'information en une forme d'onde exempte de distorsion en modifiant la valeur d'amplitude instantanée dudit signal d'information en fonction de la grandeur de ladite valeur d'amplitude instantanée et en fonction de ladite relation décrite par ladite fonction de transfert,
lesdits moyens formant circuit de transfert (58A, 58B; 100A, 100B; 200A, 200B) comprenant :
une première mémoire (102),
des moyens (103) pour générer périodiquement des données incrémentielles,
des moyens (101) de contrôle de mémoire pour inscrire dans ladite première mémoire (102), à des adresses qui correspondent à l'amplitude de la forme d'onde de référence détectée, les données correspondant à une période des données incrémentielles, et pour extraire de la première mémoire (102), à partir d'adresses qui correspondent à l'amplitude dudit signal d'information, les données incrémentielles,
une seconde mémoire (104) mémorisant une forme d'onde de référence identique à la forme d'onde de référence insérée par lesdits moyens d'insertion (17, 18, 19), ladite seconde mémoire (104) réagissant auxdites données incrémentielles extraites de ladite première mémoire (102) en extrayant la forme d'onde de référence mémorisée dans cette dernière en tant que ladite forme d'onde exempte de distorsion.

3. Appareil de traitement de signal pour traiter un signal d'information analogique, comprenant :
des moyens d'insertion de référence (17, 18, 19) pour générer une forme d'onde de référence et l'insérer, à des intervalles périodiques, dans ledit signal d'information, la plage de niveaux de signal de ladite forme d'onde de référence couvrant toute la plage de niveaux de signal dudit signal d'information,
des moyens de détection de référence (56A, 56B) pour détecter dans le signal d'information la forme d'onde de référence insérée, la forme d'onde de référence détectée étant affectée par des erreurs qui peuvent être présentes dans l'appareil, et
des moyens formant circuit de transfert (58A, 58B; 100A, 100B; 200A, 200B) ayant une fonction de transfert décrivant la relation entre ladite forme d'onde de référence insérée par lesdits moyens d'insertion (17, 18, 19) et la forme d'onde de référence affectée par des erreurs pour transformer la forme d'onde dudit signal d'information en une forme d'onde exempte de distorsion en modifiant la valeur d'amplitude instantanée dudit signal d'information en fonction de la grandeur de ladite valeur d'amplitude instantanée et en fonction de ladite relation décrite par ladite fonction de transfert, lesdits moyens formant circuit de transfert (58A, 58B; 100A, 100B; 200A, 200B) comprenant :
des moyens de génération de forme d'onde (203,204) pour générer une forme d'onde de référence identique à ladite forme d'onde de référence insérée par lesdits moyens d'insertion (17, 18, 19),
une mémoire (202), et
des moyens de contrôle de mémoire (201) pour écrire dans ladite mémoire (202), à des adresses qui correspondent à l'amplitude de ladite forme d'onde de référence détectée, la valeur d'amplitude instantanée de ladite forme d'onde de référence générée par lesdits moyens de génération de forme d'onde (203, 204), et pour extraire de ladite mémoire (202), à partir d'adresses qui correspondent à l'amplitude dudit signal d'information en tant que ladite forme d'onde exempte de distorsion, la valeur d'amplitude mémorisée.

4. Appareil d'enregistrement et de reproduction vidéo adapté pour recevoir un signal vidéo, comprenant :
des moyens de séparation de canaux (15) pour séparer ledit signal vidéo en une première composante de canal comportant des lignes numérotées par des numéros impairs et en une deuxième composante de canal comportant des lignes numérotées par des numéros pairs,
des moyens d'insertion de référence (17, 18, 19) pouvant fonctionner durant le mode d'enregistrement de l'appareil pour générer une forme d'onde de référence et insérer celle-ci dans une période suppression verticale de chacune desdites première et deuxième composantes de canaux et pour appliquer lesdites composantes à un milieu d'enregistrement par l'intermédiaire des premiers et deuxièmes moyens formant transducteurs (24, 44, 25, 46), respectivement, ladite plage de niveaux de signal de ladite forme d'onde de référence couvrant toute la plage de niveaux de signal, depuis le niveau du blanc jusqu'au niveau du noir, dudit signal vidéo,
des premiers moyens de détection de référence (56A) couplés auxdits premiers moyens formant transducteurs (24, 44) pour détecter la forme d'onde de référence de la première composante de canal reproduite par les premiers moyens formant transducteurs (24, 44) durant le mode de lecture de l'appareil, la forme d'onde de référence détectée étant affectée par des erreurs qui peuvent être présentes dans l'appareil,
des deuxièmes moyens de détection de référence (56B) couplés auxdits deuxièmes moyens formant transducteurs (25, 46) pour détecter la forme d'onde de référence de la deuxième composante de canal reproduite par les deuxièmes moyens formant transducteurs (25, 46) durant le mode de lecture de l'appareil, la forme d'onde de référence détectée étant affectée par des erreurs qui peuvent être présentes dans l'appareil,
des premiers moyens formant circuit de transfert (58A; 100A; 200A) recevant ladite première composante de canal reproduite et la forme d'onde de référence détectée par lesdits premiers moyens de détection (56A), les premiers moyens formant circuit de transfert (58A; 100A; 200A) ayant une première fonction de transfert décrivant la relation entre ladite forme d'onde de référence insérée par lesdits moyens d'insertion (17, 18, 19) et la forme d'onde de référence affectée par des erreurs et détectée par les premiers moyens de détection (56A) pour transformer la forme d'onde de ladite première composante de canal reproduite en une première forme d'onde exempte de distorsion en modifiant la valeur d'amplitude instantanée de ladite première composante de canal en fonction de la grandeur de ladite valeur d'amplitude instantanée et en fonction de ladite relation décrite par ladite première fonction de transfert,
des deuxièmes moyens formant circuit de transfert (58B, 100B; 200B) recevant ladite deuxième composante de canal reproduite et la forme d'onde de référence détectée par lesdits deuxièmes moyens de détection (56B), les deuxièmes moyens formant circuit de transfert (58B; 100B; 200B) ayant une deuxième fonction de transfert décrivant la relation entre ladite forme d'onde de référence insérée par lesdits moyens d'insertion (17, 18, 19) et la forme d'onde de référence affectée par des erreurs et détectée par lesdits deuxièmes moyens de détection (56B) pour transformer la forme d'onde de ladite deuxième composante de canal reproduite en une deuxième forme d'onde exempte de distorsion en modifiant la valeur d'amplitude instantanée de ladite deuxième composante de canal en fonction de l'amplitude de ladite valeur d'amplitude instantanée et en fonction de ladite relation décrite par ladite deuxième fonction de transfert, et
des moyens de recombinaison de canaux (59) pour recombiner les signaux de sortie desdits premiers et deuxième moyens formant circuit de transfert (58A, 58B; 100A, 100B; 200A, 200B) et pour générer un signal qui est une réplique dudit signal vidéo,
lesdits premiers moyens formant circuit de transfert (58A; 100A; 200A) comprenant :
des premiers moyens de génération de forme d'onde (71, 72) pour générer une première forme d'onde de référence identique à la forme d'onde de référence insérée par lesdits moyens d'insertion (17, 18, 19),
des premiers moyens de détection de différence (70) pour détecter des premières différences entre la forme d'onde de référence affectée par des erreurs et détectée par lesdits premiers moyens de détection (56A) et la première forme d'onde de référence identique, lesdits premiers moyens de détection de différence comprenant une première mémoire (73) et des premiers moyens de contrôle de mémoire (74) pour écrire dans ladite première mémoire (73), à des adresses qui correspondent à l'amplitude de ladite forme d'onde de référence affectée par des erreurs, lesdites premières différences détectées, et pour extraire de la mémoire (73), à partir d'adresses qui correspondent à l'amplitude de ladite première composante de canal reproduite les premières différences mémorisées, et
des premiers moyens de correction (75) pour corriger ladite première composante de canal reproduite à l'aide des différences détectées par lesdits premiers moyens de détection de différence (70,73, 74) afin d'obtenir ladite première forme d'onde exempte de distorsion, et
lesdits deuxièmes moyens formant circuit de transfert (58B; 100B; 200B) comprenant :
des deuxièmes moyens de génération de forme d'onde pour générer une deuxième forme d'onde de référence identique à la forme d'onde de référence insérée par lesdits moyens d'insertion (17, 18, 19),
des deuxièmes moyens de détection de différence pour détecter des deuxièmes différences entre la forme d'onde de référence détectée par lesdits deuxièmes moyens de détection (56B) et lesdites deuxièmes formes d'onde identiques, lesdits deuxièmes moyens de détection de différence comprenant une deuxième mémoire et des deuxièmes moyens de contrôle de mémoire pour écrire dans ladite deuxième mémoire, à des adresses qui correspondent à l'amplitude de ladite forme d'onde de référence affectée par des erreurs, lesdits deuxièmes différences détectées, et pour extraire de la mémoire, à partir d'adresses qui correspondent à l'amplitude de ladite deuxième composante de canal reproduite, les deuxièmes différences mémorisées, et
des deuxièmes moyens de correction pour corriger ladite deuxième composante de canal reproduite à l'aide des différences détectées par lesdits deuxièmes moyens de détection de différence, afin d'obtenir ladite deuxième forme d'onde exempte de distorsion.

5. Appareil d'enregistrement et de reproduction vidéo adapté pour recevoir un signal vidéo, comprenant :
des moyens de séparation de canaux (15) pour séparer ledit signal vidéo en une première composante de canal comportant des lignes numérotées par des numéros impairs et une seconde composante de canal comportant des lignes numérotées par des numéros pairs.
des moyens d'insertion de référence (17, 18, 19) pouvant fonctionner durant le mode d'enregistrement de l'appareil pour générer une forme d'onde de référence et l'insérer dans une période de suppression verticale de chacune desdites première et deuxième composantes de canal et pour appliquer lesdites composantes à un milieu d'enregistrement par l'intermédiaire des premiers et deuxièmes moyens formant transducteur (24, 44, 25 46), respectivement, la plage de niveaux de signal de ladite forme d'onde de référence couvrant toute la plage de niveaux d'un signal, depuis le niveau du blanc jusqu'au niveau du noir, dudit signal vidéo,
des premiers moyens de détection de référence (56A) couplés auxdits premiers moyens formant transducteur (24, 44) pour détecter la forme d'onde de référence de la première composante de canal reproduite par les premiers moyens formant transducteurs (24, 44) durant le mode de lecture de l'appareil, la forme d'onde de référence détectée étant affectée par des erreurs qui peuvent être présentes dans l'appareil,
des deuxièmes moyens de détection de référence (56B) couplés auxdits deuxièmes moyens formant transducteur (25, 46) pour détecter la forme d'onde de référence de la deuxième composante de canal reproduite par les deuxièmes moyens formant transducteurs (25, 46) durant le mode de lecture de l'appareil, la forme d'onde de référence détectée étant affectée par des erreurs qui peuvent être présentes dans l'appareil,
des premiers moyens formant circuit de transfert (58A; 100A; 200A) recevant ladite première composante de canal reproduite et la forme d'onde de référence détectée par lesdits premiers moyens de détection (56A), les premiers moyens formant circuit de transfert (58A; 100A; 200A) ayant une première fonction de transfert décrivant la relation entre ladite forme d'onde de référence insérée par lesdits moyens d'insertion (17, 18, 19) et la forme d'onde de référence affectée par des erreurs et détectée par lesdits premiers moyens de détection (56A) pour transformer la forme d'onde de ladite première composante de canal reproduite en une première forme d'onde exempte de distorsion en modifiant une valeur d'amplitude instantanée de ladite première composante de canal en fonction de la grandeur de ladite valeur d'amplitude instantanée et en fonction de ladite relation décrite par ladite première fonction de transfert,
des deuxièmes moyens formant circuit de transfert (58B; 100B; 200B) recevant ladite deuxième composante de canal reproduite et la forme d'onde de référence détectée par lesdits deuxièmes moyens de détection (56B), les deuxièmes moyens formant circuit de transfert (58B; 100B; 200B) ayant une seconde fonction de transfert décrivant la relation entre ladite forme d'onde de référence insérée par lesdits moyens d'insertion (17, 18, 19) et la forme d'onde de référence affectée par des erreurs et détectée par lesdits deuxièmes moyens de détection (56B) pour transformer la forme d'onde de ladite deuxième composante de canal reproduite en une deuxième forme d'onde exempte de distorsion en modifiant la valeur d'amplitude instantanée de ladite deuxième composante de canal en fonction de la grandeur de ladite valeur d'amplitude instantanée et en fonction de ladite relation décrite par ladite deuxième fonction de transfert, et
des moyens de recombinaison de canaux (59) pour recombiner des signaux de sortie arrivant desdits premiers et deuxièmes moyens formant circuit de transfert (58A, 58B; 100A, 100B; 200A, 200B) et générer un signal qui est une réplique dudit signal vidéo,
lesdits premiers moyens formant circuit de transfert (58A; 100A; 200A) comprenant :
une première mémoire (102),
des premiers moyens de génération de données périodiques (103) pour générer périodiquement des premières données incrémentielles,
des premiers moyens de contrôle de mémoire (101) pour écrire dans ladite première mémoire (102), à des adresses qui correspondent à l'amplitude de la forme d'onde de référence détectée par lesdits premiers moyens de détection de référence (56A), les données correspondant à une période des premières données incrémentielles et pour extraire de la première mémoire (102), à partir des adresses qui correspondent à l'amplitude de ladite première composante de canal reproduite, les premières données incrémentielles, et
une deuxième mémoire (104) mémorisant une première forme d'onde de référence identique à la forme d'onde de référence inséréé par lesdits moyens d'insertion (17, 18, 19), ladite première forme d'onde de référence mémorisée dans ladite deuxième mémoire (104) étant extraite en réponse auxdites premières données incrémentielles extraites de ladite première mémoire (102) pour obtenir ladite première forme d'onde exempte de distorsion, et lesdits deuxièmes moyens formant circuit de transfert (58B; 100B; 200B) comprenant :
une troisième mémoire,
des deuxièmes moyens de génération de données périodiques pour générer périodiquement des deuxièmes données incrémentielles,
des deuxièmes moyens de commande de mémoire pour écrire dans ladite troisième mémoire, à des adresses qui correspondent à l'amplitude de la forme d'onde de référence détectée par lesdits deuxièmes moyens de détection de référence (56B), les données correspondant à une période des deuxième données incrémentielles, et pour extraire de la troisième mémoire, à partir d'adresses qui correspondent à l'amplitude de ladite deuxième composante de canal reproduite les deuxièmes données incrémentielles, et
une quatrième mémoire mémorisant une deuxième forme d'onde de référence identique à la forme d'onde de référence insérée par lesdits moyens d'insertion (17, 18, 19), ladite deuxième forme d'onde de référence mémorisée dans ladite quatrième mémoire étant extraite en réponse auxdites deuxièmes données incrémentielles extraites de ladite troisième mémoire, pour obtenir ladite deuxième forme d'onde exempte de distorsion.

6. Appareil d'enregistrement et de reproduction vidéo selon la revendication 5, dans lequel chacun desdits premiers et deuxièmes moyens de génération de données périodiques (103) comprend :
des moyens de génération d'horloge pour générer une impulsion d'horloge en synchronisme avec ledit signal vidéo reproduit, et
un compteur d'adresses pour compter ladite impulsion d'horloge et générer, de façon cyclique, une série de données d'adresses en tant que chacune desdites données incrémentielles.

7. Appareil d'enregistrement et de reproduction vidéo adapté pour recevoir un signal vidéo, comprenant :
des moyens de séparation de canaux (15) pour séparer ledit signal vidéo en une première composante de canal ayant des lignes numérotées par des numéros impairs et une seconde composante de canal ayant des lignes numérotés par des numéros pairs,
des moyens d'insertion de référence (17, 18, 19) pouvant fonctionner durant le mode d'enregistrement de l'appareil pour générer une forme d'onde de référence et l'insérer dans une période de suppression verticale de chacune desdites première et seconde composantes de canal et pour appliquer lesdites composantes à un milieu d'enregistrement par l'intermédiaire de premiers et deuxièmes moyens formant transducteurs (24, 44, 25, 46) respectivement, la plage de niveaux de signal de ladite forme d'onde de référence couvrant toute la plage de niveaux de signal, depuis le niveau du blanc jusqu'au niveau du noir, dudit signal vidéo,
des premiers moyens de détection de référence (56A) couplés auxdits premiers moyens formant transducteurs (24, 44) pour détecter la forme d'onde de référence de la première composante de canal reproduite par le premier moyen formant transducteur (24, 44) durant le mode de lecture de l'appareil, la forme d'onde de référence détectée étant affectée par des erreurs qui peuvent être présentes dans l'appareil,
des deuxièmes moyens de détection de référence (56B) couplés auxdits deuxièmes moyens formant transducteurs (25, 46) pour détecter la forme d'onde de référence de la deuxième composante de canal reproduite par les deuxièmes moyens formant transducteurs (25, 46) pendant le mode de lecture de l'appareil, la forme d'onde de référence détectée étant affectée par des erreurs qui peuvent être présentes dans l'appareil,
des premiers moyens formant circuit de transfert (58A, 100A; 200A) recevant ladite première composante de canal reproduite et la forme d'onde de référence détectée par lesdits premiers moyens de détection (56A), les premiers moyens formant circuit de transfert (58A; 100A; 200A) comportant une première fonction de transfert décrivant la relation entre ladite forme d'onde de référence insérée par lesdits moyens d'insertion (17, 18, 19) et la forme d'onde de référence affectée par des erreurs et détectée par lesdits premiers moyens de détection (56A) pour transformer la forme d'onde de ladite première composante de canal reproduite en une première forme d'onde exempte de distorsion en modifiant la valeur d'amplitude instantanée de ladite première composante de canal en fonction de la grandeur de ladite valeur d'amplitude instantanée et en fonction de ladite relation décrite par ladite première fonction de transfert,
des deuxièmes moyens formant circuit de transfert (58B; 100B; 200B) recevant ladite deuxième composante de canal reproduite et la forme d'onde de référence détectée par lesdites deuxièmes moyens de détection (56B), les deuxièmes moyens formant circuit de transfert (58B; 100B, 200B) ayant une deuxième fonction de transfert décrivant la relation entre ladite forme d'onde de référence insérée par lesdits moyens d'insertion (17, 18, 19) et la forme d'onde de référence affectée par des erreurs et détectée par lesdits deuxièmes moyens de détection (56B) pour transformer la forme d'onde de ladite deuxième composante de canal reproduite en une deuxième forme d'onde exempte de distorsion en modifiant la valeur d'amplitude instantanée de ladite deuxième composante de canal en fonction de la grandeur de ladite valeur d'amplitude instantanée et en fonction de ladite relation décrite par ladite deuxième fonction de transfert, et
des moyens de recombinaison de canaux (59) pour recombiner les signaux de sortie desdits premiers et deuxièmes moyens formant circuit de transfert (58A, 58B; 100A; 200A, 200B) et pour générer un signal qui est une réplique dudit signal vidéo,
lesdits premiers moyens formant circuit de transfert (58A; 100A; 200A) comprenant :
des premiers moyens de génération de formes d'onde (203, 204) pour générer une première forme d'onde de référence identique à ladite forme d'onde de référence insérée par lesdits moyens d'insertion (17, 18, 19),
une première mémoire (202), et
des premiers moyens de contrôle de mémoire (101) pour écrire dans ladite première mémoire (202), à des adresses qui correspondent à l'amplitude de la forme d'onde de référence affectée par des erreurs et détectée par lesdits premiers moyens de détection de référence (56A), la valeur d'amplitude instantanée de ladite première forme d'onde de référence, et pour extraire de ladite première mémoire (202), à partir d'adresses qui correspondent à l'amplitude de ladite première composante de canal reproduite, la valeur d'amplitude mémorisée, pour obtenir ladite première forme d'onde exempte de distorsion, et
lesdits deuxièmes moyens formant circuit de transfert (58B; 100B; 200B) comprenant :
des deuxièmes moyens de génération de forme d'onde pour générer une deuxième forme d'onde de référence identique à ladite forme d'onde de référence insérée par lesdits moyens d'insertion (17, 18, 19),
une seconde mémoire, et
des seconds moyens de contrôle de mémoire pour écrire dans ladite deuxième mémoire, à des adresses qui correspondent à l'amplitude de la forme d'onde de référence affectée par des erreurs et détectée par lesdits deuxièmes moyens de détection de référence (56B), la valeur d'amplitude instantanée de ladite deuxième forme d'onde de référence, et pour extraire de ladite deuxième mémoire, à partir d'adresses qui correspondent à l'amplitude de ladite deuxième composante de canal, la valeur d'amplitude mémorisée, afin d'obtenir ladite deuxième forme d'onde exempte de distorsion.
